# EUROPEAN PATENT SPECIFICATION

(11) **EP 0 371 192 B1**
(45) Date of publication and mention of the grant of the patent: **03.02.1993**
(21) Application number: 89110589.2
(22) Date of filing: 12.06.1989
(51) Int. Cl.: G01R 19/04, G01R 19/25

(54) **Electric quantity detecting method**
Verfahren zum Nachweis elektrischer Grössen
Méthode pour détecter des quantités électriques

(30) Priority: 16.11.1988 JP 290701/88
(43) Date of publication of application: 06.06.1990
(73) Proprietor: MITSUBISHI DENKI KABUSHIKI KAISHA, Tokyo 100 (JP)
(72) Inventor: Suzuki, Sunao Mitsubishi Denki Kabushiki Kaisha, Hyogo-ku Kobe-shi Hyogo (JP)
(74) Representative: Eisenführ, Speiser & Partner

(56) References cited:
- EP-A- 0 322 518
- DE-A- 2 314 870
- PATENT ABSTRACTS OF JAPAN, vol. 7, no. 134 (P-203)[1279], 11th June 1983;& JP-A-58 51 315
- PATENT ABSTRACTS OF JAPAN, vol. 7, no. 212 (P-224)[1357], 20th September 1983; & JP-A-58 106 468

## Description

### BACKGROUND OF THE INVENTION

### Field of the Invention

The present invention relates to detecting methods of amplitude value of electric quantity such as alternating voltage, alternating current or the like in electric system, and more particularly to a detecting method where frequency characteristics regarding quantity to be detected are improved so as to obtain the amplitude value with little error.

### Description of the Prior Art

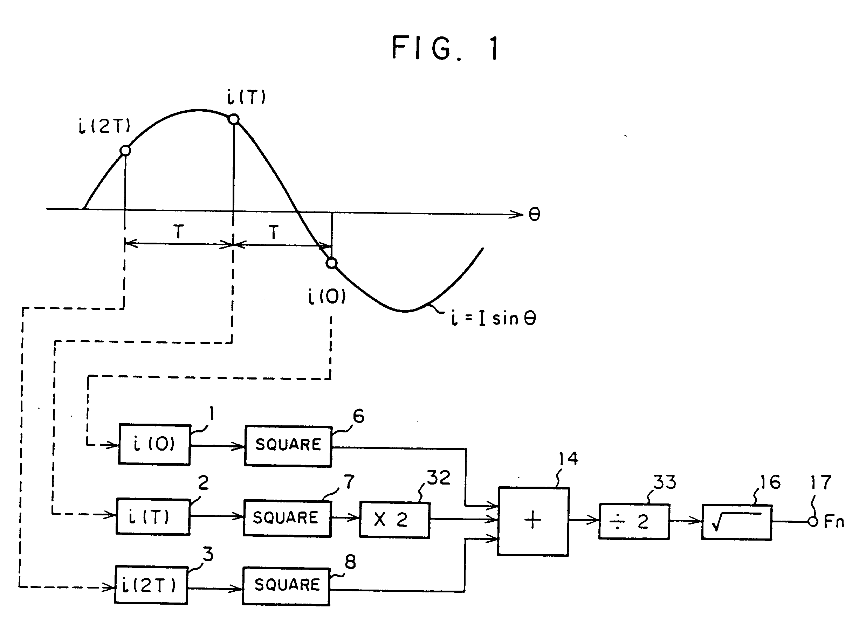

FIG. 1 is a diagram explaining principle of a digital processing device of AC electric quantity in the prior art, for example, disclosed in JP-A-1173877 where sampling is performed per every electric angle 90° of alternating current and its amplitude value is estimated using three data. In FIG. 1, assuming that sampling value 1 in the present is made i(0), sampling value 2 at time before the present by one period (T) is made i(T) and sampling value 3 at time before the present by two periods (2T) is made i(2T), and respective sampling values 1 - 3 are squared in square operation steps 6 - 8, and result of only the square operation step 7 is doubled in a twice operation step 32.

Results obtained in the square operation steps 6 and 8 and the twice operation step 32 are added in adding operation step 14 so as to obtain the sum total. If the sum total is divided by two in a dividing operation step 33 and its square root is estimated in a square root operation step 16, its output Fₙ is obtained at a terminal 17 and becomes amplitude value of the alternating current.

Next, operation will be described. For convenience of explanation, the AC electric quantity shall be alternating current, and its maximum value is made I, instantaneous value i is made i = I sinϑ, fundamental frequency is made f₀, and sampling period is 1/4 of the period of the fundamental frequency f₀ and made T. In order to distinguish data per sampling time, nT (n = 0, 1, 2, ..., and n = 0 shall be the present time) is used as suffix, and i is expressed as i(0), i(T), i(2T), ...

This is expressed by following formula (1).

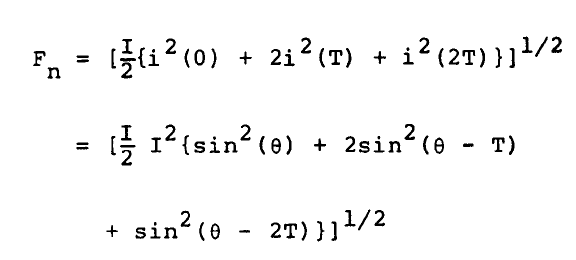

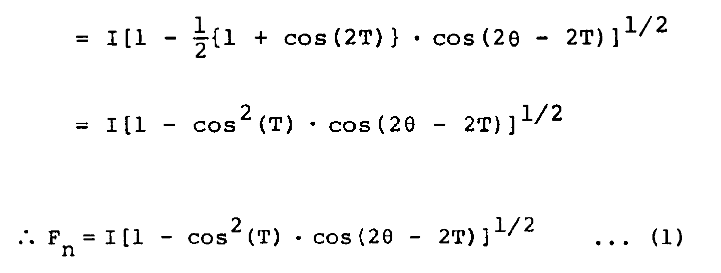

The sampling period T is fixed to 1/4 period with respect to the fundamental frequency f₀ of the alternating current, i.e., the time interval corresponding to 90° in electric angle. If the frequency is f, the sampling period T is expressed by following formula (2).$\text{T =} \frac{\text{f}}{\text{f₀ x 4}} \text{x 360°}$

For example, if frequency of the alternating current f = f₀ = 50 Hz, the sampling period becomes T = 90°.

In general, since the electric power system is operated in the rated frequency f₀, formula (1) becomes Fₙ = I and amplitude value operation of the current is possible and this is utilized, for example, in an AC overcurrent protective relay, a control device or the like. However, for a protective relay to detect fault of the electric power system and a control device for detecting electric quantity to control the operating facilities, since the frequency of the electric power system is often varied from f₀, the amplitude value must be estimated accurately even if the frequency is slightly shifted. In ordinary cases, error of the amplitude value must be reduced as much as possible to variation of the frequency of about ±5%.

If the frequency becomes f = 52.2 Hz (5% increase of 50 Hz), the sampling period becomes T = 94.5° and substituting this in formula (1), Fₙ becomes${\text{F}}_{\text{n}} {\text{= I{1 - 0.0062cos(2ϑ - 189°)}}}^{\text{1/2}}$
in form that oscillation waveform of twice frequency is superposed with constant value. Since cos(2ϑ - 189°) can be varied in range of +1.0 to -1.0, formula (3) becomes${\text{F}}_{\text{n}} \text{= 0.997 I to 1.003 I}$
thereby error of -3.0% to +0.3% is produced in comparison to the amplitude value operation in the case of the rated frequency 50 Hz.

Since electric quantity detecting method in the prior art is constituted in each operation step as above described and performs the amplitude value operation, problem exists in that the amplitude value operation error is relatively large when the frequency varies about ±5%.

### SUMMARY OF THE INVENTION

An object of the invention is to provide electric quantity detecting method wherein only two sampling values are increased in comparison to the prior art thereby even in the frequency is varied the amplitude value operation error can be reduced.

Another object of the invention is to provide electric quantity detecting method wherein little sampling values are used by only increasing two values in comparison to the prior art and the complicated operation processing step is not required and therefore the high speed operation processing becomes possible.

The foregoing and other objects and novel features of the invention will more fully appear from the following detailed description when the same is read in connection with the accompanying drawings. It is to be expressly understood, however, that the drawings are for purpose of illustration only and is not intended as a definition of the limits of the invention.

In electric quantity detecting method according to the invention, five sampling values are used and the first - fifth sampling values are squared respectively, and at the same time the square values of the second and fourth sampling values are multiplied by four and the square value of the third sampling value is multiplied by six, and then the sum total of these values is obtained in each operation processing thereby the amplitude value is operated.

Consequently, in amplitude value operation of the electric quantity detecting method according to the invention, sampling values as small as five are used and the operation result can be obtained at high speed, and even if the frequency is varied the operation is performed at high accuracy, thereby performance of a digital protective relay or a control device can be significantly improved.

### BRIEF DESCRIPTION OF THE DRAWINGS

FIG. 1 is a block diagram illustrating amplitude value operating method in the prior art;
FIG. 2 is a block diagram illustrating principle of amplitude value operating method as an embodiment of the invention;
FIG. 3 is the diagrams illustrating frequency characteristics of amplitude value operation result obtained by operating method of the prior art and the invention; and
FIG. 4 is a block diagram illustrating hardware constitution of an electric quantity detector to realize the operating method of the invention.

### DETAILED DESCRIPTION OF THE PREFERRED EMBODIMENTS

An embodiment of the invention will now described in the case of sampling the current in electric power system referring to the accompanying drawings.

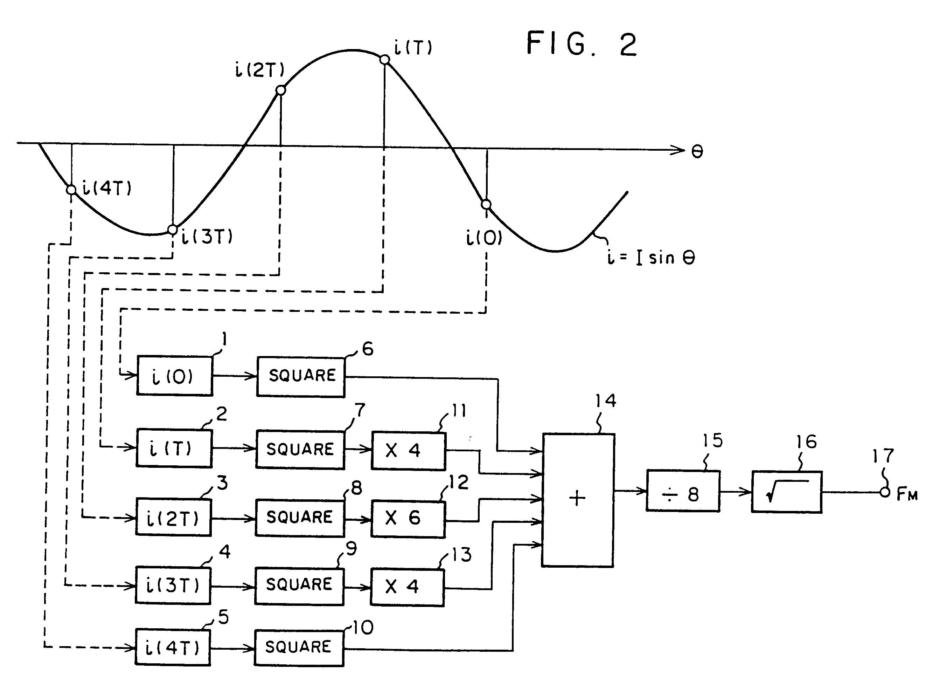

In FIG. 2, sampling values 1 - 5 in the time t - nT (n = 0, 1, 2, 3, 4) apart from the present sampling time t by the prescribed sampling number n are made i (0), i(T), i(2T), i(3T), i(4T), and the respective sampling values 1 - 5 are squared in square operation steps 6 - 10, and results in the square operation steps 7 and 9 among these steps are multiplied by four in four-times operation steps 11 and 13 and result in the square operation step 8 is multiplied by six in six-times operation step 12.

The results obtained in the square operation steps 6 and 10 and four-times operation steps 11 and 13 and the six-times operation step 12 are added in adding operation step 14 thereby the sum total is obtained. The sum total is divided by eight in dividing operation step 15 and its square root is estimated in square root operation step 16. The result is obtained as amplitude value output in a terminal 17.

This is expressed by following formula (5), and further by substituting the sampling instantaneous value and transforming the formula (5), following formula (6) is obtained.

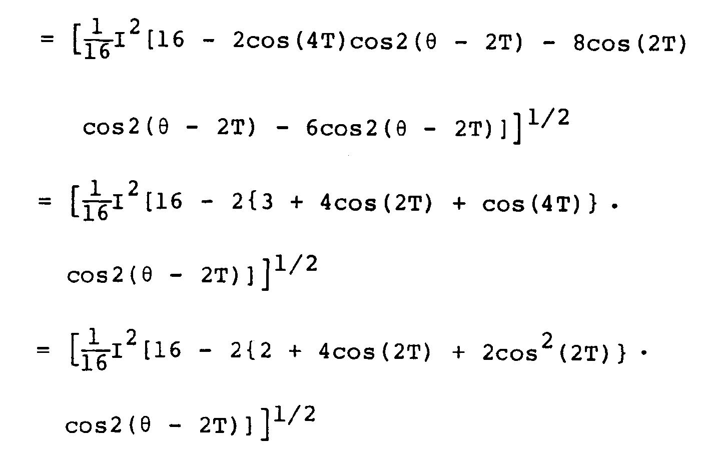

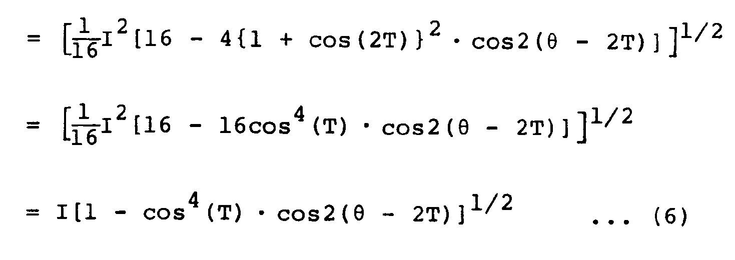

If the frequency becomes f = 52.5 Hz (5% increase of 50 Hz), the sampling period becomes T = 94.5° and substituting this in formula (6), Fₙ becomes 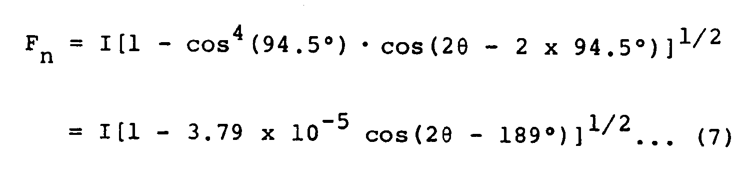
in form that oscillation waveform of amplitude 3.79 x 10⁻⁵ I and twice frequency is superposed with I. Since cos(2ϑ - 189°) can be varied in range of ±1.0 to -1.0, it follows that${\text{F}}_{\text{n}} \text{= 0.99998 I to 1.00002 I}$ thereby error of -0.002% to +0.002% is produced and becomes very small value in comparison to the amplitude value operation in the case of the rated frequency 50 Hz.

A digital protective relay compares the amplitude value operation result Fₙ thus obtained with a prescribed value (also called a set value) in amount by a comparison means although not shown and detects fault of the electric power system, and a control device utilizes the obtained Fₙ in switching control of a static capacitor or the like although not shown.

In the above description, although the output of the adding operation step 14 is processed in the dividing operation step 15 and the square root operation step 16, if setting is performed to squared value of the prescribed value (set value) of the digital protective relay or the control device, the square root operation step 16 may be obviated, and if setting is performed to value that the prescribed value (set value) is squared and multiplied by eight, the dividing operation step 15 and the square root operation step 16 may be obviated. Also in the embodiment, although the outputs of the square operation steps 7, 9 are multiplied by four in the four-times operation steps 11, 13 respectively, similar result can be obtained, of course, also by known change of the operation rule such that sum of the square operation steps 7, 9 is estimated and multiplied by four, and this is included in the invention.

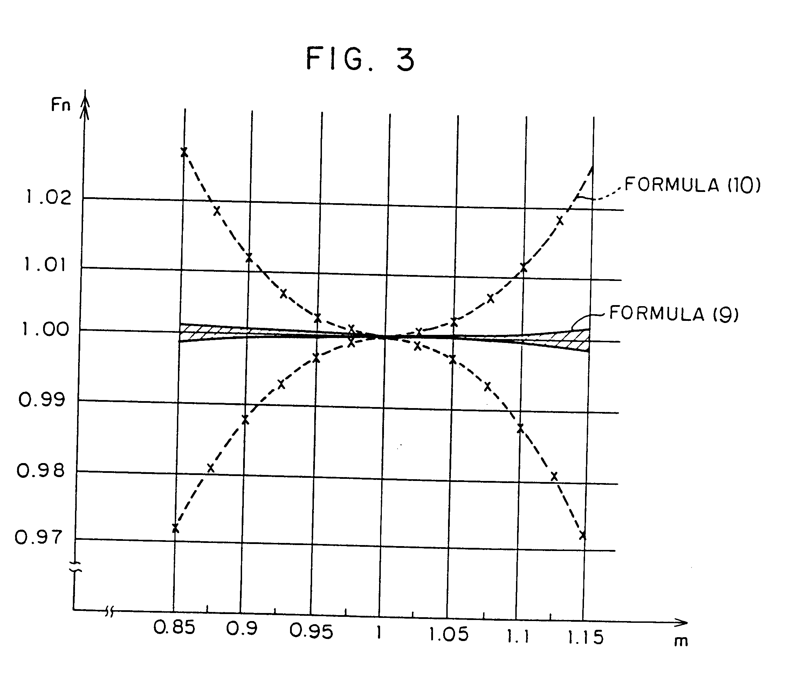

Variation state of the amplitude value operation result Fₙ in the case of varying the frequency will now be described referring to FIG. 3.

If ratio of the frequency f after the variation and the rated frequency f₀ is represented by$\text{m =} \frac{\text{f}}{\text{f₀}} \text{,}$ following formula (9) is obtained from formula (2) and formula (6).

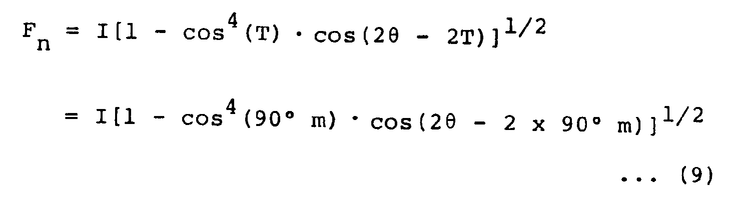

If m in the formula (9) is varied and shown in the figure, hatched portion in FIG. 3 can be obtained, and it is seen that variation of amount becomes little in the vicinity of m = 1 (f = f₀) and error of the amplitude value operation result becomes minimum.

Also if formula (1) in the prior art is expressed using m, following formula (10) is obtained and shown by dotted line in FIG. 3. It is clearly seen that error becomes little in the operation processing according to the invention.${\text{F}}_{\text{n}} {\text{= I[1 - cos²(90° m) · cos(2ϑ - 2 x 90° m)]}}^{\text{1/2}}$

Since the sampling values used in the amplitude value operation including the sampling value in prescribed time can be realized by five sampling values, the result can be obtained in the time corresponding to 90° x 5 = 450°, thereby high speed operation can be realized in scarcely varying state in comparison to the prior art, and also the memory amount required for the calculation processing can be realized in scarcely varying state.

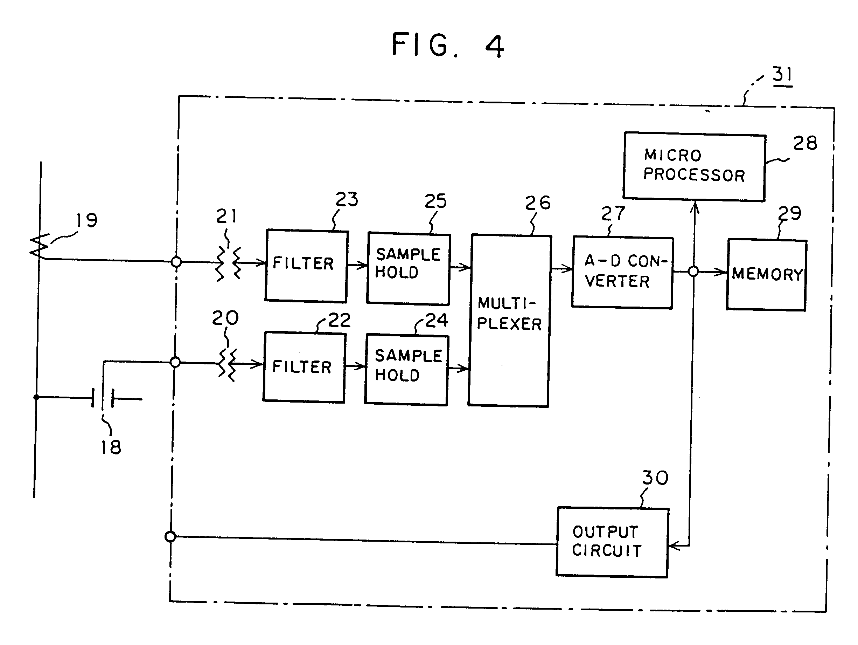

FIG.4 is a hardware constitution diagram of an electric quantity detector 31 realizing the amplitude value operation. In FIG. 4, numeral 18 designates a potential transformer, numeral 19 designates a current transformer, numerals 20, 21 designate input converters which convert voltage and current of the electric power system into values to be easily processed, and numerals 22, 23 designate filters which eliminate frequencies being 1/2 of the sampling frequency or more among harmonics included in voltage and current as known well. Numerals 24, 25 designate sample hold circuits which hold the sampling values to next sampling period. Numeral 26 designates a multiplexer which changes outputs of the sample hold circuits 24, 25 in sequence and transmit them to an A-D converter 27. Numeral 28 designates a microprocessor which executes operation utilizing program previously stored in a memory 29 and outputs the result to an output circuit 30. Numeral 31 designates an electric quantity detector.

In the embodiment, although the description is performed in the case of estimating the amplitude value of alternating current, similar effect can be obtained also when the alternating current is phase current, line current of the electric power system, or symmetrical component obtained from the phase current and the line current, i.e., positive-phase-sequence current, negative-phase-sequence current or zero-phase-sequence current, further in the case of alternating voltage. If formula (5) is expressed as general formula including these, the amplitude value Y becomes

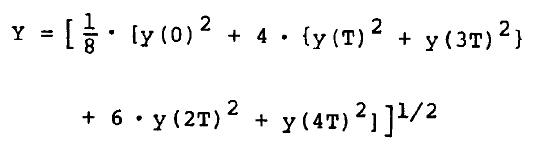

As above described, according to the electric quantity detecting method of the invention, five sampling values are used continuously and each sampling value is squared, and the second and fourth squared values are multiplied by four and the third squared value is multiplied by six and the sum total is obtained. Since the amplitude value is operated through each operation processing, even if frequency characteristics of the AC electric quantity are varied about ±5%, the amplitude value can be operated with good accuracy and the operation result can be obtained at high speed.

## Claims

1. Electric quantity detecting method comprising:
sampling step of sampling an AC electric quantity in an electric system at period T being 1/4 of the period at the rated frequency of said AC electric quantity and obtaining sampled values;
analog/digital conversion step of converting said sampled values from analog values into digital values; and
operation processing step of performing operation processing based on the sampled values subjected to the digital conversion according to a previously programmed procedure and detecting the amplitude value of the electric quantity of said electric power system,
wherein from said sampled values y(t), y(t - T), y(t - 2T), y(t - 3T), y(t - 4T) obtained in said sampling step at times t - nT (n = 0, 1, 2, 3, 4) apart from the present sampling time t by the prescribed sampling number n of periods T, the operation processing in the operation processing step is performed in operation procedure based on following formula 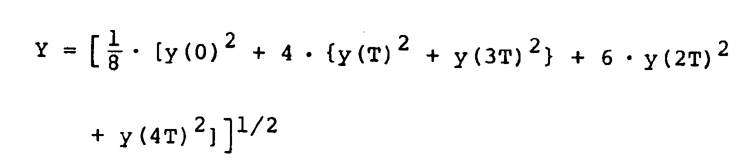 and the amplitude value of the AC electric quantity is detected.

2. Electric quantity detecting method as set forth in claim 1, wherein said AC electric quantity in the electric system is any one among phase current, line current of the electric power system or respective positive-phase-sequence current, negative-phase-sequence current, zero-phase-sequence current obtained from each of the phase current and the line current.

3. Electric quantity detecting method as set forth in claim 1, wherein said AC electric quantity in the electric system is any one among phase voltage, line voltage of the electric power system or respective positive-phase-sequence voltage, negative-phase-sequence voltage, zero-phase-sequence voltage obtained from each of the phase voltage and the line voltage.

## Patentansprüche

1. Verfahren zum Nachweis elektrischer Größen mit: einem Schritt zum Abtasten einer elektrischen AC-Größe in einem elektrischen System bei einer Periode T, die 1/4 der Periode bei der Nennfrequenz der elektrischen AC-Größe beträgt, und zum Erhalt der abgetasteten Werte; einem Analog/Digital-Wandlungsschritt zur Umwandlung der abgetasteten Werte von Analogwerten in Digitalwerte; und einem Operationsverarbeitungsschritt zur Durchführung einer Operationsverarbeitung auf der Grundlage der abgetasteten, der Digitalwandlung unterworfenen Werte gemäß einer zuvor programmierten Prozedur und zur Ermittlung des Amplitudenwertes der elektrischen Größe des elektrischen Spannungssystems,
wobei aus den abgetasteten Werten y(t), y(t - T), y(t - 2T), y(t - 3T), y(t - 4T), die man im Abtastschritt zu den Zeiten t - nT (n = 0, 1, 2, 3, 4), ausgenommen die augenblickliche Abtastzeit t, durch die vorgeschriebene Abtastzahl n der Perioden T erhalten hat, die Operationsverarbeitung im Operationsverarbeitungsschritt in einer Operationsprozedur auf der Grundlage der folgenden Gleichung 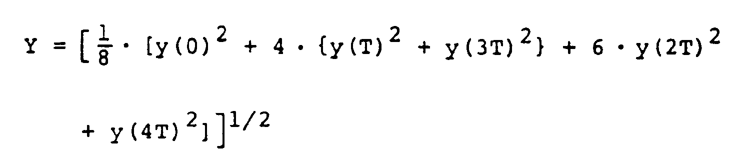 durchgeführt und der Amplitudenwert der elektrischen AC-Größe ermittelt wird.

2. Verfahren zum Nachweis elektrischer Größen nach Anspruch 1, bei welchem die elektrische AC-Größe im elektrischen System der Wert eines Phasenstromes oder eines Leitungsstromes des elektrischen Spannungssystems oder der entsprechende Strom einer positiven Phase, einer negativen Phase oder einer Nullphase, den man aus dem Phasenstrom und dem Leitungsstrom erhält, ist.

3. Verfahren zum Nachweis elektrischer Größen nach Anspruch 1, bei welchem die elektrische AC-Größe im elektrischen System ein Wert einer Phasenspannung oder Leitungsspannung des elektrischen Spannungssystems oder eine entsprechende Spannung der positiven Phase, der negativen Phase oder der Nullphase, die man aus der Phasenspannung und der Leitungsspannung erhält, ist.

## Revendications

1. Procédé de détection d'une quantité électrique comprenant :
- une étape d'échantillonnage pour échantillonner une quantité électrique AC dans un dispositif électrique sur une période T d'un 1/4 de la période à la fréquence nominale de ladite quantité électrique AC et d'obtention de valeurs échantillonnées;
- une étape de conversion analogique/digitale pour convertir lesdites valeurs échantillonnées à partir des valeurs analogiques en valeurs digitales et
- une étape de traitement de l'opération pour réaliser un traitement de l'opération sur la base des valeurs échantillonnées soumises à la conversion digitale selon la procédure programmée précédemment et pour détecter la valeur d'amplitude de la quantité électrique dudit dispositif de puissance électrique,
procédé selon lequel, à partir desdites valeurs échantillonnées y(t), y(t - T), y(t - 2T), y(t - 3T), y(t - 4T) obtenues à ladite étape d'échantillonnage aux instants t - nT (n = 0, 1, 2, 3, 4) différents de l'instant présent d'échantillonnage t du nombre prescrit n de périodes T d'échantillonnage, le traitement de l'opération à l'étape de traitement de l'opération est réalisé dans la procédure d'opération sur la base de la formule suivante:${\text{Y = [1/8·[y(0)² + 4 · {y(T)² + y(3T)²} + 6 · y(2T)² + y(4T)²]]}}^{\text{1/2}}$ et la valeur d'amplitude de la quantité électrique AC est détectée.

2. Procédé de détection d'une quantité électrique selon la revendication 1, selon lequel ladite quantité électrique AC du dispositif électrique est une quelconque parmi le courant de phase, le courant de ligne du dispositif de puissance électrique ou les courants respectifs de phase positive, de phase négative, de phase nulle obtenus à partir de chacun des courants de phase et de ligne.

3. Procédé de détection d'une quantité électrique selon la revendication 1, selon lequel ladite quantité électrique AC du dispositif électrique est une quelconque parmi la tension de phase, la tension de ligne du dispositif de puissance électrique ou les tensions respectives de phase positive, de phase négative, de phase nulle obtenues à partir de chacune des tensions de phase et de ligne.
